# EUROPÄISCHE PATENTSCHRIFT

(11) **EP 4 530 579 B1**
(45) Veröffentlichungstag und Bekanntmachung des Hinweises auf die Patenterteilung: **28.10.2026**
(21) Anmeldenummer: 23200215.4
(22) Anmeldetag: 27.09.2023
(51) Int. Cl.: G01D 3/08, G01D 4/00, G01R 11/24, G01R 22/06, G01R 22/10

(54) **COMPUTERIMPLEMENTIERTES VERFAHREN ZUR KOMPENSATION EINES MESSAUSFALLS EINES SMART-METERS**
COMPUTER-IMPLEMENTED METHOD FOR COMPENSATING A MEASUREMENT FAILURE OF A SMART METER
PROCÉDÉ MIS EN OEUVRE PAR ORDINATEUR POUR COMPENSER UNE DÉFAILLANCE DE MESURE D'UN COMPTEUR INTELLIGENT

(43) Veröffentlichungstag der Anmeldung: 02.04.2025
(73) Patentinhaber: Siemens Aktiengesellschaft, 80333 München (DE)
(72) Erfinder: EINFALT, Alfred, 1210 Wien (AT); DIWOLD, Konrad, 1180 Wien (AT)
(74) Vertreter: Siemens Patent Attorneys

(56) Entgegenhaltungen:
- EP-A2- 2 400 310
- WO-A1-2021/194338
- DE-A1- 102017 211 737
- DE-B4- 19 681 530

## Beschreibung

### GEBIET DER ERFINDUNG

Die Erfindung betrifft ein computerimplementiertes Verfahren zur Kompensation eines Messausfalls eines Smart-Meters in einem Niederspannungsnetz, wobei Zeitreihen von numerischen Messdaten über ein System umfassend
- das Niederspannungsnetz,
- zumindest ein erstes Smart-Meter, welches eine Zeitreihe von numerischen Messdaten des ersten Smart-Meters liefert,
- ein zweites Smart-Meter, welches eine Zeitreihe von numerischen Messdaten des zweiten Smart-Meters liefert,
- sowie einen Prozessor und einen Speicher, erstellt werden. Die Erfindung umfasst auch ein entsprechendes Computerprogrammprodukt sowie eine entsprechende computerimplementierte Vorrichtung.

Unter einem Messausfall wird hier verstanden, dass das Smart-Meter entweder keine Messwerte liefert oder die Messwerte nicht ordnungsgemäß an den Prozessor übertragen werden.

### STAND DER TECHNIK

Ausgangspunkt ist das unterschiedliche Belastungsprofil des Stromnetzes im ländlichen Raum, wo beispielsweise Einspeisungen aus privaten Photovoltaikanlagen zu Spannungsproblemen führen können, und im urbanen Raum, wo eine Gefahr der Betriebsmittelüberlastung wegen einer hohen Besiedelungsdichte und damit einhergehend einer hohen Zahl an Verbrauchern auf kleinem Raum zu Problemen hinsichtlich der Stromstärke führen kann.

Zur Begegnung dieser Problematik kann einerseits der Ausbau des Stromnetzes forciert werden, der jedoch kostspielig und langwierig ist. Alternativ können Lösungen gesucht werden, wie die bestehende Infrastruktur besser genutzt werden kann. Dafür ist eine intelligente Steuerung innerhalb des Stromnetzes, auch Smart Grid genannt, unter Einsatz von beispielsweise Speicher- und Regelungstechnologie, unbedingt erforderlich.

Grundlage für eine solche intelligente Steuerung sind jedenfalls umfangreiche und möglichst detaillierte Messdaten über das zu steuernde Niederspannungsnetz. Als Messinstrumente bieten sich hierfür aus dem Stand der Technik heraus bekannte Smart-Meter an. Die Verbreitung dieser, primär zur einfachen, kostengünstigen und kundenfreundlichen Verrechnung des Energieverbrauches installierten Geräte, nimmt konstant zu. Um ordnungsgemäß funktionieren zu können, erheben diese Geräte am jeweiligen Punkt des Niederspannungsnetzes eine Vielzahl an Messwerten, die zur Verrechnung an den oder die Energieanbieter auch weitergeleitet werden müssen. Daher umfassen diese Geräte auch Einrichtungen zur Fernkommunikation und können grundsätzlich als Mess-Sensoren mit Kommunikationsanschluss verwendet werden.

In der Regel stehen für die Weiterleitung der von den Smart-Metern erhobenen Daten allerdings keine eigenen Kommunikationstechnologien zur Verfügung, sodass auch etablierte Mobilkommunikationsstandards wie GPRS zurückgegriffen werden muss.

Gerade in der Nähe hoher elektrischer Felder wie in Verteiler- oder Zählerkästen, wo sich Smart-Meter üblicherweise befinden, kommt es oft zur Störung der Datenverbindung oder zum Ausfall derselben, sodass die grundsätzlich vorhandenen Messdaten nicht dauerhaft aus der Ferne zur Verfügung stehen. Genau das ist aber für eine intelligente Steuerung des Stromnetzes erforderlich.

Die Druckschrift DE 10 2017 211737 A1 offenbart eine Überwachungsvorrichtung zur Auswertung von Sensordaten, bei der beim Ausfall eines Sensors virtuelle Sensordaten auf Basis verbleibender funktionsfähiger Sensoren durch eine zweistufige Auswahl erstellt werden, wobei zunächst Sensorkandidaten auf Grundlage eines wissensbasierten Ansatzes ermittelt und dann mathematische Beziehungen zwischen den Sensordaten berechnet werden.

Die Druckschrift DE 196 81 530 B4 beschreibt ein Verfahren zum Detektieren und Identifizieren fehlerhafter Messfühler in einem Prozess, bei dem eine Hauptkomponentenanalyse zur Erzeugung von Messfühler-Schätzsignalen verwendet und ein Messfühler-Gültigkeitsindex als Funktion von Resten bestimmt wird, die die Differenz zwischen Schätz- und Ausgangssignalen bezeichnen.

Die Druckschrift EP 2 400 310 A2 offenbart ein Verfahren und System zur Bestimmung der Gesundheit eines Messsystems, bei dem Fehlerzustände verschiedener Schweregrade detektiert und gewichtet werden, um einen einzigen Wert für die Gesundheit des Energiemessgeräts zu bestimmen.

Die Druckschrift WO 2021/194338 A1 beschreibt ein Verfahren zur Bereitstellung von Kommunikation mit einer verteilten Vielzahl elektronischer Versorgungsmessgeräte, bei dem Zwischengeräte an den jeweiligen Messgeräten bereitgestellt werden, um verschlüsselte Nachrichten zwischen den Messgeräten und einem zentralen Prozessor weiterzuleiten, ohne den verschlüsselten Zustand der Nachrichten zu verändern.

Die Grenzen des Stands der Technik bestehen somit insbesondere darin, dass durchgehende, lückenlose Zeitreihen an Messdaten zu physikalisch-elektrischen Messgrößen in Niederspannungsnetzen mit Smart-Metern zwar grundsätzlich zur Verfügung stehen, aber auf sie aufgrund der oben genannten Probleme in der Mobilkommunikation nicht zuverlässig und dauerhaft zugriffen werden kann.

### AUFGABE DER ERFINDUNG

Aufgabe der Erfindung ist es daher, die beschriebenen Grenzen des Standes der Technik dahingehend zu überwinden, dass ein Weg zur Gewährleistung lückenlos verfügbarer Zeitreihen zu physikalisch- elektrotechnischen Messgrößen auf Basis der durch Smart-Meter grundsätzlich bereitstehenden Messdaten beschrieben wird. Damit soll der Netzbetreiber seine Regelund Überwachungsaufgaben auch bei instabilen Datenübertragungsverhältnissen zuverlässig erfüllen können und das Niederspannungsnetz so näher an seiner absoluten Auslastungsgrenze betrieben werden können.

Dazu soll grundsätzlich im Niederspannungsnetz vorhandene Information, wie die aufgrund allgemeiner physikalischer und elektrotechnischer Grundlagen vorhandenen Impedanzschwankungen innerhalb von Netzabschnitten, die einzelne Smart-Meter im Niederspannungsnetz miteinander verbinden, ausgenutzt werden.

### DARSTELLUNG DER ERFINDUNG

Zur Lösung der Aufgabe der Erfindung vorgestellt wird ein computerimplementiertes Verfahren zur Kompensation eines Messausfalls eines Smart-Meters in einem Niederspannungsnetz, wobei Zeitreihen von numerischen Messdaten über ein System umfassend das Niederspannungsnetz,
zumindest ein erstes Smart-Meter, welches eine Zeitreihe von numerischen Messdaten des ersten Smart-Meters liefert, ein zweites Smart-Meter, welches eine Zeitreihe von numerischen Messdaten des zweiten Smart-Meters liefert, sowie einen Prozessor und einen Speicher, erstellt werden, dadurch gekennzeichnet, dass der Prozessor einen Autoencoder umfasst, der trainiert ist, Zeitreihen des ersten Smart-Meters auf Zeitreihen des zweiten Smart-Meters zu übersetzen,
dass das erste Smart-Meter und das zweite Smart-Meter in definierten Zeitabständen Messungen von physikalischen Größen betreffend das Niederspannungsnetz vornehmen und so die Zeitreihe von numerischen Messdaten des ersten Smart-Meters und die Zeitreihe von numerischen Messdaten des zweiten Smart-Meters erstellt wird und wobei für den Fall, dass das zweite Smart-Meter fehlerfrei arbeitet, die Zeitreihe von numerischen Messdaten des ersten Smart-Meters und die Zeitreihe von numerischen Messdaten des zweiten Smart-Meters über eine, insbesondere drahtlose, Datenübertragungsstrecke an den Speicher übertragen werden und für den Fall, dass das zweite Smart-Meter ausgefallen ist und keine Zeitreihe von numerischen Messdaten des zweiten Smart-Meters liefert, die Zeitreihe von numerischen Messdaten des ersten Smart-Meters über eine, insbesondere drahtlose, Datenübertragungsstrecke an den Speicher übertragen wird und die Zeitreihe von numerischen Messdaten des zweiten Smart-Meters im Speicher vom Autoencoder, auf Basis der Zeitreihe von numerischen Messdaten des ersten Smart-Meters, durch eine virtuelle Zeitreihe von numerischen Messdaten des zweiten Smart-Meters ersetzt wird.

Ein Autoencoder, welcher autonom arbeitet, ist ein künstliches neuronales Netz, das dazu genutzt wird, effiziente Codierungen zu lernen. Der Autoencoder liefert eine maschinelle Übersetzung von einem Eingangssignal (Input) auf ein Ausgangssignal (Output), hierzu wird im Training ein Eingangssignal auf eine komprimierte Repräsentation gemappt, um diese Repräsentation dann in einem zweiten Schritt wieder auf ein Ausgangssignal zu mappen.

Das erfindungsgemäße Verfahren realisiert somit eine maschinelle Übersetzung einer Zeitreihe eines als Sensor verwendeten Smart-Meters in eine Zeitreihe eines anderen solchen Sensors im selben Zeitintervall. Das erfindungsgemäße Verfahren stellt eine maschinelle Übersetzung von Zeitreihen von Messdaten von Smart-Metern in Zeitreihen von Messdaten von anderen im Niederspannungsnetz befindlichen Smart-Metern dar. Der Input des Autoencoders sind die Daten eines bestimmten Smart-Meters in einem vorgegebenen, festen Zeitintervall, der Output die Daten eines anderen Smart-Meters im selben Zeitintervall.

In der Regel umfasst das Niederspannungsnetz eine Vielzahl von Smart-Metern, wobei das erfindungsgemäße Verfahren grundsätzlich für jedes Paar von Smart-Metern anwendbar ist und in der Regel auch angewendet wird. Der Autoencoder wird daher sehr viele, insbesondere jedes Smart-Meter, des Niederspannungsnetzes, mit sehr vielen anderen, insbesondere allen anderen, Smart-Metern des Niederspannungsnetzes verknüpfen.

In einer besonderen Ausführungsform des erfindungsgemäßen Verfahrens ist der Prozessor ein im Niederspannungsnetz integriertes Edge-Device.

Diese Ausführungsform bietet den zusätzlichen Vorteil, dass das erfindungsgemäße Verfahren lokal im Niederspannungsnetz bzw. nah am Verbraucher ausgeführt werden kann und so die erforderlichen Datenübertragungsstrecken kurz gehalten und damit weniger störungsanfällig ausgestaltet werden können.

In einer weiteren Ausführungsform des erfindungsgemäßen Verfahrens ist der Prozessor eine außerhalb des Niederspannungsnetzes befindliche cloudbasierte Zentralrecheneinheit.

Auf diese Weise kann die erforderliche Rechenleistung für das erfindungsgemäße Verfahren auf eine einzige Zentralrecheneinheit konzentriert werden, was eine effizientere Nutzung vorhandener Rechenleistungskapazitäten erlaubt.

In einer besonderen Ausführungsform des erfindungsgemäßen Verfahrens ist der Speicher ein im Niederspannungsnetz integrierter lokaler Speicher.

Auf diese Weise können wiederum Datenübertragungsstrecken eingespart und das Verfahren insbesondere unter Berücksichtigung der Ausführungsform mit Verwendung eines Edge-Devices lokal im Niederspannungsnetz bzw. beim Verbraucher in effizienter Weise und unabhängig von zentralen Rechenzentren ausgeführt werden.

In einer besonderen Ausführungsform des erfindungsgemäßen Verfahrens ist der Speicher ein außerhalb des Niederspannungsnetzes befindlicher cloudbasierter Zentralspeicher.

Vorteil dieser Ausführungsform ist eine Einsparungsmöglichkeit im Bereich der Speichermedien, da ein großer Zentralspeicher effizienter und kostengünstiger arbeitet als eine Vielzahl kleiner Speichermedien. Insbesondere wenn der Prozessor eine cloudbasierte Zentralrechneneinheit ist, kann diese schnell auf den ebenfalls cloudbasierten Zentralspeicher zugreifen und damit der vom Prozessor umfasste Autoencoder unabhängig von Datenübertragungsproblemen aus dem Niederspannungsnetz seine Aufgaben erfüllen.

Im erfindungsgemäßen Verfahren ist vorgesehen, dass die Zeitreihen von numerischen Messdaten des ersten Smart-Meters und gegebenenfalls die Zeitreihen von numerischen Messdaten des zweiten Smart-Meters über eine weitere, insbesondere drahtlose, Datenübertragungsstrecke an eine Recheneinheit umfassend einen Historienspeicher und eine KI-Einheit übertragen und dort gespeichert werden, sowie dass die KI-Einheit mit dem Historienspeicher datenleitend verbunden ist und aus der Vielzahl der dort gespeicherten Zeitreihen von numerischen Messdaten des ersten und des zweiten Smart-Meters die virtuelle Zeitreihe von numerischen Messdaten des zweiten Smart-Meters dergestalt neu berechnet, dass die betragsmäßige Differenz, im Sinn einer Summe der Differenzen aller Einträge der jeweiligen Zeitreihe, der Zeitreihe von numerischen Messdaten des zweiten Smart-Meters und der neu berechneten virtuellen Zeitreihe von numerischen Messdaten des zweiten Smart-Meters unterhalb eines vorgegebenen Übersetzungsfehlers liegt und dass die in dieser Art und Weise berechnete neue virtuelle Zeitreihe von numerischen Messdaten des zweiten Smart-Meters über die weitere Datenübertragungsstrecke an den Speicher übertragen und dort gespeichert wird und zum weiteren Training des Autoencoders verwendet wird und der Autoencoder des Prozessors damit aktualisiert wird.

Diese Ausführungsform stellt eine Echtzeit-Aktualisierung der simulierten Messdaten im Sinn eines "Now-Castings" dar. Als Algorithmus zur Berechnung der virtuellen numerischen Messdaten des zweiten Smart-Meters kommt nicht nur finite Boltzmann-Statistik mit anschließender Rückwärts-Zeitentwicklung in Betracht, sondern auch nichtlineare Methoden der künstlichen Intelligenz wie beispielsweise das Gradientenabstiegsverfahren. Der oben genannte Übersetzungsfehler als Maß der Güte der errechneten/simulierten Messdaten kann als Integration der Differenz der errechneten zur letzten verfügbaren gemessenen Messdatenzeitreihe im betreffenden Zeitintervall implementiert sein. Das Training des Autoencoders entspricht dabei einer Verbesserung desselben im Sinn eines Upgrades des dem Autoencoder zugrundeliegenden Programmes bzw. Algorithmus zur verbesserten Version infolge des Trainings.

Mit anderen Worten wird der Autoencoder durch die mit dem Historienspeicher verbundene KI-Einheit kontinuierlich trainiert. Die mit dem Historienspeicher verbundene KI-Einheit kann beispielsweise Teil des sogenannten SCADA (Supervisory Control and Data Acquisition, deutsch: Überwachung, Steuerung und Datenerfassung) Systems des Netzbetreibers sein.

In einer besonders bevorzugten Ausführungsform des erfindungsgemäßen Verfahrens wird zur Neuberechnung der virtuellen Zeitreihe von numerischen Messdaten des zweiten Smart-Meters die Zeitreihe von numerischen Messdaten zumindest eines weiteren Smart-Meters, die über die weitere drahtlose Datenübertragungsstrecke an die Recheneinheit übertragen wird, ebenfalls herangezogen.

Damit erhält die KI-Einheit zusätzliche Informationen über das Niederspannungsnetz, in welchem das zweite Smart-Meter verbaut ist. Durch die Verwendung der Daten weiterer Smart-Meter kann eine noch genauere Vorhersage der Messdaten, welche das zweite Smart-Meter in einem gegebenen Zeitintervall liefern wird, getroffen werden und diese Vorhersage, im Vergleich zur Situation in dem nur das erste Smart-Meter als Datenquelle zur Verfügung steht, auch schneller getroffen werden. Der Vorteil dieser Ausführungsvariante betrifft also die Genauigkeit im Sinn eines geringeren Übersetzungsfehlers und eine schnellere Verfügbarkeit der virtuellen Messdaten. n Smart-Meter ergeben dabei 2ⁿ Paarkonstellationen, um gegenseitig Messdaten zu ersetzen. Permutationen sind aus dem Grund miteingeschlossen, da die Konstellation "A ersetzt die Daten des B" nicht dieselbe ist wie "B ersetzt die Daten des A".

In einer weiteren Ausführungsform des erfindungsgemäßen Verfahrens wird für den Fall, dass das zweite Smart-Meter nicht ausgefallen ist und eine Zeitreihe von numerischen Messdaten des zweiten Smart-Meters liefert, diese von der KI-Einheit ausgeblendet und die virtuelle Zeitreihe von numerischen Messdaten des zweiten Smart-Meters dennoch neu berechnet.

Mit dieser Ausführungsform des erfindungsgemäßen Verfahrens kann die Künstliche Intelligenz der KI-Einheit auch parallel zum normalen Betrieb, in dem alle im Niederspannungsnetz verbauten Smart-Meter ordnungsgemäß Messdaten liefern, trainiert werden. Durch das Ausblenden der Datensätze eines oder mehrerer Smart-Meter wird ein Ausfall desselben simuliert, wobei die tatsächlich gemessenen Daten trotzdem - zu Vergleichszwecken wie etwa der Berechnung des Übersetzungsfehlers - zur Verfügung stehen. In einer besonders einfachen Ausführungsform kann sich ein solches Verfahren an der leave-one-out-Methode (Kreuzvalidierung) orientieren.

In einer anderen Ausführungsform der Erfindung wird anstelle der Zeitreihe von numerischen Messdaten des zweiten Smart-Meters die Zeitreihe von numerischen Messdaten des ersten Smart-Meters oder die Zeitreihe von numerischen Messdaten des zumindest einen weiteren Smart-Meters ausgeblendet und die virtuelle Zeitreihe von numerischen Messdaten des zweiten Smart-Meters auf Grundlage dieser Daten neu berechnet.

In einer besonderen Ausführungsform der Erfindung wird von der KI-Einheit der Übertragungsfehler in Abhängigkeit von jenem Smart-Meter, dessen Messdaten ausgeblendet wurden, dargestellt und im Historienspeicher gespeichert und daraus jenes Smart-Meter ermittelt, dessen Ausblenden den geringsten Übersetzungsfehler verursacht.

Mit dieser Ausführungsform können besonders zuverlässige Kombinationen von Smart-Metern, also jene mit kleinem Übersetzungsfehler, aufgefunden werden, die in weiterer Folge bevorzugt zur Berechnung virtueller Messdaten herangezogen werden. Umgekehrt können besonders unzuverlässige Kombinationen von Smart-Metern, also jene mit großem Übersetzungsfehler, ausgeschlossen und in weiterer Folge nicht mehr von der KI-Einheit berücksichtigt werden, was Rechenzeit aufgrund des Vorab-Wegfalls vieler unrentabler Kombinationen an Smart-Metern einspart.

In einer besonderen Ausführungsform der Erfindung werden die virtuellen Zeitreihen von numerischen Messdaten des zweiten Smart-Meters, welche durch numerische Messdaten verschiedener Smart-Meter erhalten worden sind, punktweise gemittelt.

Mit dieser Vorgangsweise wird die Zuverlässigkeit der durch den virtuellen Datensatz getroffenen Vorhersagen zu den Messdaten eines gegebenen Smart-Meters noch weiter erhöht.

In einer besonderen Ausführungsvariante der Erfindung ist der Speicher als virtueller Speicher Teil des Historienspeichers und der Autoencoder als virtuelle Maschine Teil der KI-Einheit.

Auf diesem Weg kann weitere Hardware eingespart werden, was die Implementierung des erfindungsgemäßen Verfahrens einfacher und kosteneffizienter macht. Diese Ausführungsvariante entspricht einer Cloud-Lösung für das erfindungsgemäße Verfahren. Weiters bietet diese Asuführungsvariante auch die Möglichkeit, die Künstliche Intelligenz der KI-Einheit noch schneller zu trainieren oder den Übersetzungsfehler noch kleiner zu machen, da auf diesem Weg beispielsweise leicht die Daten eines weiteren Niederspannungsnetzes, das sich allenfalls in großer Entfernung befindet, verwendet werden können, sodass mehrere Niederspannungsnetze zu einem virtuellen großen Netzwerk zusammengefasst werden können. Mit anderen Worten kann das erfindungsgemäße Verfahren auch über viele Netzgebiete hinweg angewendet werden. D.h. es werden die Autoencoder auch dafür eingesetzt, wenn in einem Niederspannungsnetz mit bestimmtem Verhalten (bestimmt durch Lasten, Erzeuger, etc.) ein Messwert an einer kritischen Stelle ausfällt, dass ein virtueller Messpunkt erzeugt wird, indem über den Autoencoder auf Messwerte bzw. Smart-Meter in ähnlichen Netzen referenziert wird.

Ebenfalls von der Erfindung umfasst ist ein Computerprogrammprodukt wie in dem unabhängigen Anspruch 12 definiert.

Auch von der Erfindung umfasst ist eine computerimplementarierte Vorrichtung wie in dem unabhängigen Anspruch 13 definiert.

### KURZE BESCHREIBUNG DER FIGUREN

Nachfolgend wird die Erfindung anhand von Ausführungsbeispielen näher erläutert. Die Figuren sind beispielhafter Natur, sollen den Erfindungsgedanken darlegen und sind insbesondere nicht einschränkend oder gar als abschließende Wiedergabe der Erfindung zu verstehen.

Dabei zeigt:

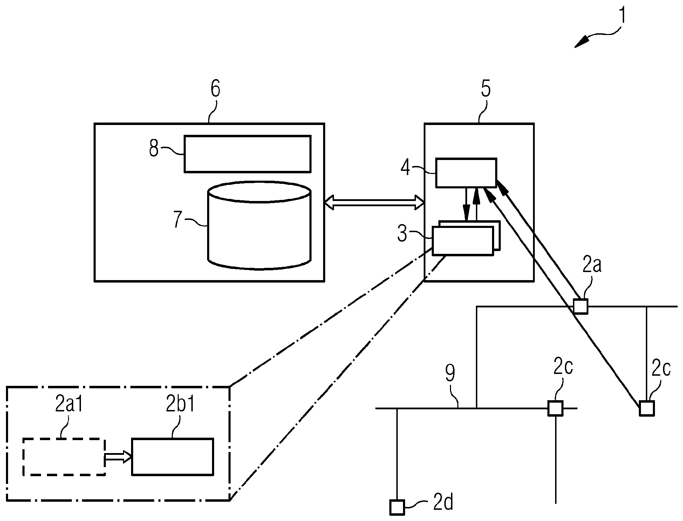

Fig. 1 eine schematische Skizze des Systems zur Ausführung des erfindungsgemäßen Verfahrens.

### WEGE ZUR AUSFÜHRUNG DER ERFINDUNG

Fig. 1 zeigt eine schematische Skizze des Systems zur Ausführung des erfindungsgemäßen Verfahrens für den Fall, dass das zweite Smart-Meter 2b ausgefallen ist und keine Zeitreihe von numerischen Messdaten des zweiten Smart-Meters 2b1 liefert.

In einem ersten Schritt des Verfahrens senden die Smart-Meter 2a-2d, welche an verschiedenen Messpunkten in einem Niederspannungsnetz 9 verbaut sind, hier insbesondere das erste Smart-Meter 2a und das zweite Smart-Meter 2b, ihre numerischen Messdaten an den lokalen Speicher 4 im Edge-Device 5. Der Messdatensatz des zweiten Smart-Meters 2b ist dabei im dargestellten Fall, wie oben erwähnt, leer.

Der Autoencoder 3 erkennt in einem nächsten Schritt diesen Umstand und ersetzt deshalb die leere Zeitreihe von numerischen Messdaten des zweiten Smart-Meters 2b1 im lokalen Speicher 4 durch eine virtuelle Zeitreihe von numerischen Messdaten des zweiten Smart-Meters 2a1, die der trainierte Autoencoder 3 auf Basis der gemessenen Zeitreihe von numerischen Messdaten des ersten Smart-Meters errechnet.

In einem parallel ablaufenden Prozess werden die im lokalen Speicher 4 hinterlegten virtuellen numerischen Messdaten des zweiten Smart-Meters 2a1 laufend aktualisiert.

Die Recheneinheit 6, umfassend einen Historienspeicher 7 und eine KI-Einheit 8, hat Zugriff auf den Prozessor 5, der hier als Edge-Device im Niederspannungsnetz 9 realisiert ist, und dessen Autoencoder 3. Die KI-Einheit 8 speichert sämtliche vom Autoencoder 3 berechnete virtuelle Zeitreihen von numerischen Messdaten sowie die vom Speicher 4 des Prozessors 5 empfangenen Messdaten, nämlich der gemessenen Zeitreihen von numerischen Messdaten, der verschiedenen Smart-Meter 2a-2d in einem Hauptspeicher 7 ab und berechnet aus diesen zeitabhängigen Daten neue virtuelle numerische Messdaten des zweiten Smart-Meters 2a1. Das ist möglich, weil sämtliche Smart-Meter 2a-2d im Niederspannungsnetz 9 miteinander verknüpft sind und daher von den einzelnen Smart-Metern an verschiedenen Stellen des Niederspannungsnetzes 9 gemessene physikalische Größen bezüglich dieses Niederspannungsnetzes 9 aufgrund allgemeiner physikalisch/elektrotechnischer Gesetzmäßigkeiten voneinander abhängen. Diese Gesetzmäßigkeiten sind aufgrund der komplexen Verzweigungen einzelner elektrischer Leitungen im Niederspannungsnetz 9 nicht linear, aber dennoch deterministisch und durch die KI-Einheit 8 durch Verfahren der Künstlichen Intelligenz, wie beispielsweise dem Gradientenabstiegsverfahren, feststellbar.

Auf diese Weise werden die Autoencoder 3 durch die KI-Einheit 8 der Recheneinheit 6 trainiert. Die Güte der Autoencoder 3 kann (bei Nichtausfall von Knoten, also von Smart-Metern 2a-2d) durch die KI-Einheit 8 kontinuierlich überprüft werden, gleichzeitig kann bei einer, aus den Berechnungen der KI-Einheit 8 resultierenden, signifikanten Verbesserung eines Autoencoders 3 ein Update des Modells des Autoencoders 3 auf dem als Edge Device ausgebildeten Autoencoder 3 erfolgen.

Auf Grundlage dieser von der KI-Einheit 8 gefundenen Gesetzmäßigkeiten und der entsprechend trainierten Autoencoder 3 werden die - in der hier vorgestellten Ausführungsform der Erfindung - fehlenden Messdaten des zweiten Smart-Meters 2b vorhergesagt und als neu berechnete virtuelle Zeitreihe von numerischen Messdaten des zweiten Smart-Meters 2a1 im lokalen Speicher 4 hinterlegt. Damit wird gewährleistet, dass die Zeitreihe an Messdaten eines Smart-Meters 2a-2d - im vorgestellten Ausführungsbeispiel des zweiten Smart-Meters 2b - stets vollständig ist, insbesondere auch dann, wenn das zweite Smart-Meter 2b ausgefallen ist oder eine Übertragung der numerischen Messdaten des zweiten Smart-Meters 2b aus anderen Gründen nicht möglich ist.

Unabhängig vom grammatikalischen Geschlecht eines bestimmten Begriffes sind Personen mit männlicher, weiblicher oder anderer Geschlechteridentität mit umfasst.

### BEZUGSZEICHENLISTE

- 1: System
- 2a: Erstes Smart-Meter
- 2a1: Virtuelle Zeitreihe von numerischen Messdaten des zweiten Smart-Meters
- 2b: Zweites Smart-Meter
- 2b1: Zeitreihe von numerischen Messdaten des zweiten Smart-Meters
- 2c, 2d: weitere Smart-Meter
- 3: Autoencoder
- 4: Speicher
- 5: Prozessor
- 6: Recheneinheit
- 7: Historienspeicher
- 8: KI-Einheit
- 9: Niederspannungsnetz

## Patentansprüche

1. Computerimplementiertes Verfahren zur Kompensation eines Messausfalls eines Smart-Meters (2a-2d) in einem Niederspannungsnetz (9), wobei Zeitreihen von numerischen Messdaten über ein System (1) umfassend
- das Niederspannungsnetz (9),
- zumindest ein erstes Smart-Meter (2a), welches eine Zeitreihe von numerischen Messdaten des ersten Smart-Meters liefert,
- ein zweites Smart-Meter (2b), welches eine Zeitreihe von numerischen Messdaten des zweiten Smart-Meters (2b1) liefert,
- sowie einen Prozessor (5) und einen Speicher (4), erstellt werden, **wobei** der Prozessor (5) einen Autoencoder (3) umfasst, der trainiert ist, Zeitreihen des ersten Smart-Meters (2a) auf Zeitreihen des zweiten Smart-Meters (2b) zu übersetzen,
das erste Smart-Meter (2a) und das zweite Smart-Meter (2b) in definierten Zeitabständen Messungen von physikalischen Größen betreffend das Niederspannungsnetz (9) vornehmen und so die Zeitreihe von numerischen Messdaten des ersten Smart-Meters und die Zeitreihe von numerischen Messdaten des zweiten Smart-Meters (2b1) erstellt wird und wobei
- für den Fall, dass das zweite Smart-Meter (2b) fehlerfrei arbeitet, die Zeitreihe von numerischen Messdaten des ersten Smart-Meters und die Zeitreihe von numerischen Messdaten des zweiten Smart-Meters (2b1) über eine, insbesondere drahtlose, Datenübertragungsstrecke an den Speicher (4) übertragen werden und
- für den Fall, dass das zweite Smart-Meter (2b) ausgefallen ist und keine Zeitreihe von numerischen Messdaten des zweiten Smart-Meters (2b1) liefert, die Zeitreihe von numerischen Messdaten des ersten Smart-Meters über eine, insbesondere drahtlose, Datenübertragungsstrecke an den Speicher (4) übertragen wird und die Zeitreihe von numerischen Messdaten des zweiten Smart-Meters (2b1) im Speicher (4) vom Autoencoder (3), auf Basis der Zeitreihe von numerischen Messdaten des ersten Smart-Meters, durch eine virtuelle Zeitreihe von numerischen Messdaten des zweiten Smart-Meters (2a1) ersetzt wird, **dadurch gekennzeichnet, dass**
- die Zeitreihen von numerischen Messdaten des ersten Smart-Meters und gegebenenfalls die Zeitreihen von numerischen Messdaten des zweiten Smart-Meters (2b1) über eine weitere, insbesondere drahtlose, Datenübertragungsstrecke an eine Recheneinheit (6) umfassend einen Historienspeicher (7) und eine KI-Einheit (8) übertragen und dort gespeichert werden, sowie dass die KI-Einheit (8) mit dem Historienspeicher (7) datenleitend verbunden ist und aus der Vielzahl der dort gespeicherten Zeitreihen von numerischen Messdaten des ersten und des zweiten Smart-Meters die virtuelle Zeitreihe von numerischen Messdaten des zweiten Smart-Meters (2b1) dergestalt neu berechnet, dass die betragsmäßige Differenz, im Sinn einer Summe der Differenzen aller Einträge der jeweiligen Zeitreihe, der Zeitreihe von numerischen Messdaten des zweiten Smart-Meters (2b1) und der neu berechneten virtuellen Zeitreihe von numerischen Messdaten des zweiten Smart-Meters (2a1) unterhalb eines vorgegebenen Übersetzungsfehlers liegt und dass die in dieser Art und Weise berechnete neue virtuelle Zeitreihe von numerischen Messdaten des zweiten Smart-Meters (2b1) über die weitere Datenübertragungsstrecke an den Speicher (4) übertragen und dort gespeichert wird und zum weiteren Training des Autoencoders (3) verwendet wird und der Autoencoder (3) des Prozessors (5) damit aktualisiert wird.

2. Computerimplementiertes Verfahren nach Anspruch 1,
**dadurch gekennzeichnet, dass** der Prozessor (5) ein im Niederspannungsnetz (9) integriertes Edge-Device (5) ist.

3. Computerimplementiertes Verfahren nach Anspruch 1,
**dadurch gekennzeichnet, dass** der Prozessor (5) eine außerhalb des Niederspannungsnetzes (9) befindliche cloudbasierte Zentralrecheneinheit ist.

4. Computerimplementiertes Verfahren nach Anspruch 1, 2 oder 3, **dadurch gekennzeichnet, dass** der Speicher (4) ein im Niederspannungsnetz (9) integrierter lokaler Speicher ist.

5. Computerimplementiertes Verfahren nach Anspruch 1, 2 oder 3, **dadurch gekennzeichnet, dass** der Speicher (4) ein außerhalb des Niederspannungsnetzes (9) befindlicher cloudbasierter Zentralspeicher ist.

6. Computerimplementiertes Verfahren nach einem der vorangehenden Ansprüche, **dadurch gekennzeichnet, dass** zur Neuberechnung der virtuellen Zeitreihe von numerischen Messdaten des zweiten Smart-Meters (2b1) die Zeitreihe von numerischen Messdaten zumindest eines weiteren Smart-Meters (2c, 2d), die über die weitere, insbesondere drahtlose, Datenübertragungsstrecke an die Recheneinheit (6) übertragen wird, ebenfalls herangezogen wird.

7. Computerimplementiertes Verfahren nach einem der vorangehenden Ansprüche, **dadurch gekennzeichnet, dass** für den Fall, dass das zweite Smart-Meter (2b) nicht ausgefallen ist und eine Zeitreihe von numerischen Messdaten des zweiten Smart-Meters (2b1) liefert, diese von der KI-Einheit (8) ausgeblendet wird und die virtuelle Zeitreihe von numerischen Messdaten des zweiten Smart-Meters (2a1) dennoch neu berechnet wird.

8. Computerimplementiertes Verfahren nach Anspruch 7,
**dadurch gekennzeichnet, dass** anstelle der Zeitreihe von numerischen Messdaten des zweiten Smart-Meters (2b) die Zeitreihe von numerischen Messdaten des ersten Smart-Meters (2a1) oder die Zeitreihe von numerischen Messdaten des zumindest einen weiteren Smart-Meters (2c, 2d) ausgeblendet und die virtuelle Zeitreihe von numerischen Messdaten des zweiten Smart-Meters (2a1) auf Grundlage dieser Daten neu berechnet wird.

9. Computerimplementiertes Verfahren nach einem der Ansprüche 7 oder 8, **dadurch gekennzeichnet, dass** von der KI-Einheit (8) der Übertragungsfehler in Abhängigkeit von jenem Smart-Meter, dessen Messdaten ausgeblendet wurden, dargestellt und im Historienspeicher (7) gespeichert wird und daraus jenes Smart-Meter ermittelt wird, dessen Ausblenden den geringsten Übersetzungsfehler verursacht.

10. Computerimplementiertes Verfahren nach einem der Ansprüche 1 bis 9, **dadurch gekennzeichnet, dass** die virtuellen Zeitreihen von numerischen Messdaten des zweiten Smart-Meters (2b1), welche durch numerische Messdaten verschiedener Smart-Meter (2a, 2c, 2d) erhalten worden sind, punktweise gemittelt werden.

11. Computerimplementiertes Verfahren nach einem der Ansprüche 1 bis 10, **dadurch gekennzeichnet, dass** der Speicher (4) als virtueller Speicher Teil des Historienspeichers (7) ist und der Autoencoder (3) als virtuelle Maschine Teil der KI-Einheit (8) ist.

12. Computerprogrammprodukt **umfassend** Instruktionen, um ein System (1) umfassend das Niederspannungsnetz (9), zumindest ein erstes Smart-Meter (2a), welches eine Zeitreihe von numerischen Messdaten des ersten Smart-Meters liefert, zumindest ein zweites Smart-Meter (2b), welches eine Zeitreihe von numerischen Messdaten des zweiten Smart-Meters (2b1) liefert, einen Prozessor (5), einen Autoencoder (3), einen Speicher (4), die Recheneinheit (6), umfassend den Hauptspeicher (7) und die KI-Einheit (8), sowie gegebenenfalls zumindest ein weiteres Smart-Meter (2c-2d), anzuweisen, alle Verfahrensschritte nach einem der Ansprüche 1 bis 11 auszuführen.

13. Computerimplementierte Vorrichtung **umfassend** zumindest das Niederspannungsnetz (9), das erste Smart-Meter (2a), das zweite Smart-Meter (2b), den Prozessor (5), den Autoencoder (3) und den Speicher (4), ferner umfassend den Hauptspeicher (7) und die KI-Einheit (8), sowie gegebenenfalls zumindest ein weiteres Smart-Meter (2c-2d), welche Vorrichtung dazu eingerichtet ist, ein Verfahren nach einem der Ansprüche 1 bis 11 auszuführen.

## Claims

1. Computer-implemented method for compensating for a measurement failure of a smart meter (2a-2d) in a low voltage network (9), wherein time series of numerical measurement data are generated via a system (1), comprising
- the low voltage network (9),
- at least one first smart meter (2a), which provides a time series of numerical measurement data of the first smart meter,
- a second smart meter (2b), which provides a time series of numerical measurement data of the second smart meter (2b1),
- and a processor (5) and a memory (4), **wherein** the processor (5) comprises an autoencoder (3) which is trained to translate time series of the first smart meter (2a) to time series of the second smart meter (2b),
the first smart meter (2a) and the second smart meter (2b) take measurements of physical variables relating to the low voltage network (9) at defined intervals and in this way the time series of numerical measurement data of the first smart meter and the time series of numerical measurement data of the second smart meter (2b1) is generated and wherein
- in the event that the second smart meter (2b) operates correctly, the time series of numerical measurement data of the first smart meter and the time series of numerical measurement data of the second smart meter (2b1) is transferred to the memory (4) via an in particular wireless data transmission link and
- in the event that the second smart meter (2b) has failed and does not provide time series of numerical measurement data of the second smart meter (2b1), the time series of numerical measurement data of the first smart meter is transferred to the memory (4) via an in particular wireless data transmission link and the time series of numerical measurement data of the second smart meter (2b1) in the memory (4) of the autoencoder (3) is replaced on the basis of the time series of numerical measurement data of the first smart meter by a virtual time series of numerical measurement data of the second smart meter (2a1), **characterised in that**
- the time series of numerical measurement data of the first smart meter and, if applicable, the time series of numerical measurement data of the second smart meter (2b1) is transferred via an additional, in particular wireless, data transmission link to a computing unit (6), where it is stored, which computing unit comprises a historical data store (7) and an AI unit (8), and that the AI unit (8) is in data communication with the historical data store (7) and the virtual time series of numerical measurement data of the second smart meter (2b1) is recalculated from the plurality of time series of numerical measurement data of the first and of the second smart meter stored there such that the absolute difference, within the meaning of a total of the differences of all entries of the respective time series, of the time series of numerical measurement data of the second smart meter (2b1) and the recalculated virtual time series of numerical measurement data of the second smart meter (2a1), lies below a predefined translation error and that the new virtual time series of numerical measurement data of the second smart meter (2b1) calculated in this manner is transferred via the additional data transmission link to the memory (4) and is stored there and is used for further training of the autoencoder (3) and the autoencoder (3) of the processor (5) is thereby updated.

2. Computer-implemented method according to claim 1, **characterised in that** the processor (5) is an edge device (5) integrated in the low voltage network (9).

3. Computer-implemented method according to claim 1, **characterised in that** the processor (5) is a cloud-based central computing unit located outside the low voltage network (9).

4. Computer-implemented method according to claim 1, 2 or 3 **characterised in that** the memory (4) is a local store integrated in the low voltage network (9).

5. Computer-implemented method according to claim 1, 2 or 3 **characterised in that** the memory (4) is a cloud-based central store located outside the low voltage network (9).

6. Computer-implemented method according to one of the preceding claims, **characterised in that**, for recalculation of the virtual time series of numerical measurement data of the second smart meter (2b1), the time series of numerical measurement data of at least one additional smart meter (2c, 2d) which is transferred via the additional, in particular wireless, data transmission link to the computing unit, is likewise used.

7. Computer-implemented method according to one of the preceding claims, **characterised in that**, in the event that the second smart meter has not failed and provides a time series of numerical measurement data of the second smart meter (2b1), this is hidden by the AI unit (8) and the virtual time series of numerical measurement data of the second smart meter (2a1) is nevertheless recalculated.

8. Computer-implemented method according to claim 7, **characterised in that** the time series of numerical measurement data of the first smart meter (2a1) or the time series of numerical measurement data of the at least one additional smart meter (2c, 2d) is hidden instead of the time series of numerical measurement data of the second smart meter (2b) and the virtual time series of numerical measurement data of the second smart meter (2a1) is recalculated on the basis of this data.

9. Computer-implemented method according to one of claims 7 or 8, **characterised in that** the translation error is displayed and stored in the historical data store (7) by way of the AI unit (8) dependant upon the smart meter whose measurement data was hidden, and that smart meter, the hiding of which causes the fewest translation errors, is determined therefrom.

10. Computer-implemented method according to one of claims 1 to 9, **characterised in that** the virtual time series of numerical measurement data of the second smart meter (2b1), which has been obtained by numerical measurement data of different smart meters (2a, 2c, 2d), is averaged on a pointby-point basis.

11. Computer-implemented method according to one of claims 1 to 10, **characterised in that** the memory (4), as a virtual memory, is part of the historical data store (7) and the autoencoder (3), as a virtual machine, is part of the AI unit (8).

12. Computer program product **comprising** instructions for instructing a system (1) comprising the low voltage network (9), at least one first smart meter (2a) which provides a time series of numerical measurement data of the first smart meter, at least one second smart meter (2b), which provides a time series of numerical measurement data of the second smart meter (2b1), a processor (5), an autoencoder (3), a memory (4), the computing unit (6), comprising the main memory (7) and the AI unit (8), and, if applicable, at least one additional smart meter (2c, 2d) to carry out all method steps according to one of claims 1 to 11.

13. Computer-implemented apparatus **comprising** at least the low voltage network (9), the first smart meter (2a), the second smart meter (2b), the processor (5), the autoencoder (3) and the memory (4), further comprising the main memory (7) and the AI unit (8), and, if applicable, at least one additional smart meter (2c-2d), which apparatus is configured to carry out a method according to one of claims 1 to 11.

## Revendications

1. Procédé mis en œuvre par ordinateur pour la compensation d'une défaillance de mesure d'un compteur intelligent (2a à 2d) dans un réseau basse tension (9), dans lequel des séries temporelles de données de mesure numériques sont établies par l'intermédiaire d'un système (1) comportant
- le réseau basse tension (9),
- au moins un premier compteur intelligent (2a), lequel fournit une série temporelle de données de mesure numériques du premier compteur intelligent,
- un deuxième compteur intelligent (2b), lequel fournit une série temporelle de données de mesure numériques du deuxième compteur intelligent (2b1),
- ainsi qu'un processeur (5) et une mémoire (4), dans lequel le processeur (5) comporte un auto-encodeur (3) qui est entraîné pour traduire des séries temporelles du premier compteur intelligent (2a) en séries temporelles du deuxième compteur intelligent (2b),
le premier compteur intelligent (2a) et le deuxième compteur intelligent (2b) effectuent, à des intervalles temporels définis, des mesures de grandeurs physiques concernant le réseau basse tension (9), et ainsi la série temporelle de données de mesure numériques du premier compteur intelligent et la série temporelle de données de mesure numériques du deuxième compteur intelligent (2b1) sont établies et dans lequel
- dans le cas où le deuxième compteur intelligent (2b) fonctionne sans erreur, la série temporelle de données de mesure numériques du premier compteur intelligent et la série temporelle de données de mesure numériques du deuxième compteur intelligent (2b1) sont transmises à la mémoire (4) par l'intermédiaire d'une ligne de transmission de données, en particulier sans fil, et
- dans le cas où le deuxième compteur intelligent (2b) est défaillant et ne fournit aucune série temporelle de données de mesure numériques du deuxième compteur intelligent (2b1), la série temporelle de données de mesure numériques du premier compteur intelligent est transmise à la mémoire (4) par l'intermédiaire d'une ligne de transmission de données, en particulier sans fil, et la série temporelle de données de mesure numériques du deuxième compteur intelligent (2b1) est remplacée dans la mémoire (4), par l'auto-encodeur (3), sur la base de la série temporelle de données de mesure numériques du premier compteur intelligent, par une série temporelle virtuelle de données de mesure numériques du deuxième compteur intelligent (2a1), **caractérisé en ce que**
- les séries temporelles de données de mesure numériques du premier compteur intelligent et éventuellement les séries temporelles de données de mesure numériques du deuxième compteur intelligent (2b1) sont transmises par l'intermédiaire d'une ligne de transmission de données supplémentaire, en particulier sans fil, à une unité de calcul (6) comportant une mémoire d'historique (7) et une unité d'IA (8) et y sont stockées, ainsi que l'unité d'IA (8) est reliée à la mémoire d'historique (7) par communication de données et recalcule, à partir de la pluralité des séries temporelles de données de mesure numériques du premier et du deuxième compteur intelligent qui y sont stockées, la série temporelle virtuelle de données de mesure numériques du deuxième compteur intelligent (2b1) de telle manière que le montant de la différence, au sens d'une somme des différences de toutes les entrées de la série temporelle respective, de la série temporelle de données de mesure numériques du deuxième compteur intelligent (2b1) et de la série temporelle virtuelle recalculée de données de mesure numériques du deuxième compteur intelligent (2a1) se situe au-dessous d'une erreur de traduction prédéfinie et que la nouvelle série temporelle virtuelle de données de mesure numériques du deuxième compteur intelligent (2b1) calculée de cette façon est transmise par l'intermédiaire de la ligne de transmission de données supplémentaire à la mémoire (4) et y est stockée et est utilisée pour l'entraînement supplémentaire de l'auto-encodeur (3), et l'auto-encodeur (3) du processeur (5) est par conséquent actualisé.

2. Procédé mis en œuvre par ordinateur selon la revendication 1, **caractérisé en ce que** le processeur (5) est un dispositif d'accès (*Edge-Device*) intégré dans le réseau basse tension (9).

3. Procédé mis en œuvre par ordinateur selon la revendication 1, **caractérisé en ce que** le processeur (5) est une unité de calcul centrale basée sur le nuage se trouvant en dehors du réseau basse tension (9).

4. Procédé mis en œuvre par ordinateur selon la revendication 1, 2 ou 3, **caractérisé en ce que** la mémoire (4) est une mémoire locale intégrée dans le réseau basse tension (9).

5. Procédé mis en œuvre par ordinateur selon la revendication 1, 2 ou 3, **caractérisé en ce que** la mémoire (4) est une mémoire centrale basée sur le nuage se trouvant en dehors du réseau basse tension (9).

6. Procédé mis en œuvre par ordinateur selon l'une des revendications précédentes, **caractérisé en ce que**, pour le recalcul de la série temporelle virtuelle de données de mesure numériques du deuxième compteur intelligent (2b1), la série temporelle de données de mesure numériques d'au moins un compteur intelligent supplémentaire (2c, 2d) qui est transmise à l'unité de calcul (6) par l'intermédiaire de la ligne de transmission de données supplémentaire, en particulier sans fil, est également consultée.

7. Procédé mis en œuvre par ordinateur selon l'une des revendications précédentes, **caractérisé en ce que**, dans le cas où le deuxième compteur intelligent (2b) n'est pas défaillant et fournit une série temporelle de données de mesure numériques du deuxième compteur intelligent (2b1), celle-ci est masquée par l'unité d'IA (8) et la série temporelle virtuelle de données de mesure numériques du deuxième compteur intelligent (2a1) est néanmoins recalculée.

8. Procédé mis en œuvre par ordinateur selon la revendication 7, **caractérisé en ce que**, à la place de la série temporelle de données de mesure numériques du deuxième compteur intelligent (2b), la série temporelle de données de mesure numériques du premier compteur intelligent (2a1) ou la série temporelle de données de mesure numériques de l'au moins un compteur intelligent supplémentaire (2c, 2d) est masquée et la série temporelle virtuelle de données de mesure numériques du deuxième compteur intelligent (2a1) est recalculée sur la base de ces données.

9. Procédé mis en œuvre par ordinateur selon l'une des revendications 7 ou 8, **caractérisé en ce que** l'erreur de transmission est représentée par l'unité d'IA (8) en fonction du compteur intelligent dont des données de mesure ont été masquées et est stockée dans la mémoire d'historique (7), et à partir de cela, le compteur intelligent dont le masquage provoque la plus faible erreur de traduction est déterminé.

10. Procédé mis en œuvre par ordinateur selon l'une des revendications 1 à 9, **caractérisé en ce que** les séries temporelles virtuelles de données de mesure numériques du deuxième compteur intelligent (2b1) qui ont été obtenues par le biais de données de mesure numériques de différents compteurs intelligents (2a, 2c, 2d) sont moyennées point par point.

11. Procédé mis en œuvre par ordinateur selon l'une des revendications 1 à 10, **caractérisé en ce que** la mémoire (4) fait partie de la mémoire d'historique (7) en tant que mémoire virtuelle et l'auto-encodeur (3) fait partie de l'unité d'IA (8) en tant que machine virtuelle.

12. Produit de programme informatique comportant des instructions afin de donner l'ordre à un système (1) comprenant le réseau basse tension (9), au moins un premier compteur intelligent (2a), lequel fournit une série temporelle de données de mesure numériques du premier compteur intelligent, au moins un deuxième compteur intelligent (2b), lequel fournit une série temporelle de données de mesure numériques du deuxième compteur intelligent (2b1), un processeur (5), un auto-encodeur (3), une mémoire (4), l'unité de calcul (6), comportant la mémoire principale (7) et l'unité d'IA (8), ainsi qu'éventuellement au moins un compteur intelligent supplémentaire (2c à 2d), d'exécuter toutes les étapes de procédé selon l'une des revendications 1 à 11.

13. Dispositif mis en œuvre par ordinateur comportant au moins le réseau basse tension (9), le premier compteur intelligent (2a), le deuxième compteur intelligent (2b), le processeur (5), l'auto-encodeur (3) et la mémoire (4), comprenant en outre la mémoire principale (7) et l'unité d'IA (8), ainsi qu'éventuellement au moins un compteur intelligent supplémentaire (2c à 2d), lequel dispositif est conçu pour exécuter un procédé selon l'une des revendications 1 à 11.
